# EUROPÄISCHE PATENTANMELDUNG

(11) **EP 1 471 611 A2**
(43) Veröffentlichungstag der Anmeldung: **27.10.2004**
(21) Anmeldenummer: 04100565.3
(22) Anmeldetag: 13.02.2004
(51) Int. Cl.: H01R 24/00

(54) **Flexibles Folienkabel**

(30) Priorität: 01.04.2003 DE 10314909
(71) Anmelder: SIEMENS AKTIENGESELLSCHAFT, 80333 München (DE)
(72) Erfinder: Rother, Markus, 35745, Herborn (DE); Wendrich, Michael, 35579, Wetzlar (DE)

(57) **Zusammenfassung**

Die Erfindung betrifft ein mehrpoliges Verbindungskabel, das als flexibles Flachkabel (1) mit mehreren nebeneinander angeordneten Leiterbahnen (2) ausgebildet und an mindestens einem Kabelende mit einem Stecker (5) versehen ist, wobei die Leiterbahnen (2) am Kabelende elektrisch mit Kontaktflächen (8) des Steckers (5) verbunden sind und das Flachkabel (1) und der Stecker (5) Mittel (3, 9) zum Zentrieren des Flachkabels (1) in dem Stecker (5) aufweisen. Erfindungsgemäß ist vorgesehen, dass die Breite der Kontaktflächen (8) und/oder der Abstand (10) benachbarter Kontaktflächen (8) sowie daran angepasst die Breite der Leiterbahnen und/oder der Abstand (4) benachbarter Leiterbahnen (2) unterschiedlich ist.

## Beschreibung

Die Erfindung betrifft ein mehrpoliges Verbindungskabel, das als flexibles Flachkabel mit mehreren nebeneinander angeordneten Leiterbahnen ausgebildet und an mindestens einem Kabelende mit einem Stecker versehen ist, wobei die Leiterbahnen am Kabelende elektrisch leitend mit Kontaktflächen des Stekkers kontaktiert sind und das Flachkabel und der Stecker Mittel zum Zentrieren des Flachkabels in dem Stecker aufweisen. Weiterhin betrifft die Erfindung einen Stecker mit in einer Ebene angeordneten Kontaktflächen zur Herstellung einer elektrischen Verbindung zu Leiterbahnen eines Flachkabels und einem Eingriffselement zur Zentrierung des Flachkabels in dem Stecker.

Ein derartiges Kabel und ein derartiger Stecker sind aus der GB-A-2 262 847 bekannt.

Mehrpolige Verbindungskabel, bei denen das Flachkabel als mit Leiterbahnen versehenen Folie ausgebildet ist, sogenannte FPC-Folien (FPC: Flexible Printed Circuit), werden häufig zur Verbindung von Leiterplatten untereinander eingesetzt. Hierzu kann die FPC-Folie direkt mit der Leiterplatte verbunden werden, d.h. die Leiterbahnen der FPC-Folie werden mit entsprechenden Leiterbahnen der Leiterplatte verlötet. Bei einer derartigen Verbindung ist eine weitgehend freie Gestaltung der FPC-Folie möglich. Nachteilig ist hierbei jedoch, dass eine schnelle Trennung der Verbindung nicht ohne weiteres möglich ist. Daher werden FPC-Folien auch über gesteckte Folienverbindungen mit einer Leiterplatte verbunden. Hierzu weist die Leiterplatte einen entsprechenden Stecker auf, in den die FPC-Folie eingesteckt wird. Derartige Stecker werden häufig auch als ZIF-Stecker (ZIF: Zero Insertion Force) oder FFC-Verbinder (FFC: Flat Foil Cable) bezeichnet.

Mehrpolige FFC-Verbindungen mit kleinen Abständen zwischen den Leiterbahnen bzw. zwischen den entsprechenden Kontaktflächen des Steckers (sogenannte Pitch-Abstände) weisen teilweise unterschiedliche Toleranzen bei der FPC-Folie und dem Stecker auf. Diese unterschiedlichen Toleranzen können dazu führen, dass Leiterbahnen der FPC-Folie nur eine geringe oder im Extremfall keine Überdeckung mehr zu den Kontaktflächen des Steckers aufweisen. Dies kann zum sofortigen oder frühzeitigen Ausfall des Geräts führen. Durch die aus der oben genannten GB-A-2 226 847 bekannte Zentrierung des Kabels im Stecker mittels einer Aussparung im Kabel und eines Eingriffelements im Stecker kann die Positionierung des Kabels im Stecker bereits verbessert werden.

Aufgabe der Erfindung ist es, ein derartiges mehrpoliges Verbindungskabel bzw. einen derartigen Stecker weiterzuentwickeln, um eine noch sicherere Überlappung zwischen den Kontaktflächen des Steckers und den Leiterbahnen des Kabels bei hohen Polzahlen zu erreichen.

Die Aufgabe wird bei einem gattungsgemäßen Verbindungskabel dadurch gelöst, dass die Breite der Kontaktflächen und/oder der Abstand benachbarter Kontaktflächen sowie daran angepasst die Breite der Leiterbahnen und/oder der Abstand benachbarter Leiterbahnen unterschiedlich ist. Ausgehend von einer Zentrierung des Kabels in dem Stecker wächst bei mehrpoligen Verbindungen die Gefahr einer fehlenden Überlappung zwischen Leiterbahn und zugehöriger Kontaktfläche im Stecker aufgrund der sich addierenden Einzeltoleranzen bzw. -abweichungen der Leiterbahnen und Kontaktflächen mit zunehmenden Abstand von diesem Zentrierelement. Dem wird durch die unterschiedliche Breite der Kontaktflächen und/oder des Abstandes benachbarter Kontaktflächen sowie daran angepasst der Breite der Leiterbahnen und/oder dem Abstand benachbarter Leiterbahnen Rechnung getragen. Um die mit wachsendem Abstand von dem Zentrierelement zunehmende Abweichung zwischen der Position einer Leiterbahn und einer Kontaktfläche auszugleichen, wird daher die Breite der Kontaktfläche und die Breite der Leiterbahn bzw. der Abstand benachbarter Kontaktflächen und der Abstand benachbarter Leiterbahnen erhöht. Bei weiter vom Zentrierelement entfernten Leiterbahnen bzw. Kontaktflächen wird durch die zunehmende Breite eine ausreichende Überlappung zwischen Leiterbahn und Kontaktfläche sichergestellt.

Vorzugsweise umfassen die Mittel zum Zentrieren des Flachkabels eine mittig in Querrichtung des Flachkabels angeordnete Aussparung, in die ein Eingriffselement des Steckers eingreift. Durch die mittige Zentrierung des Kabels im Stecker können die Toleranzen gegenüber einer Randzentrierung halbiert werden, da der Abstand zwischen der Zentrierung und der entferntesten Kontaktfläche nur halb so groß ist wie bei einer Randzentrierung.

In einer bevorzugten Ausführungsform sind die Aussparung und das Eingriffselement keilförmig ausgebildet. Durch eine derartige keilförmige Mittenzentrierung wird das Führungsspiel beim Einführen des Kabels in den Stecker eliminiert.

Vorzugsweise ist das Verbindungskabel so ausgelegt, dass der Abstand zwischen benachbarten Leiterbahnen von der mittig ausgelegten Aussparung in beide Richtungen zum Kabelrand hin wächst. Hierdurch können die sich zum Kabelrand hin addierenden Toleranzen besonders gut ausgeglichen werden.

In einer besonderen Ausführungsform ist vorgesehen, dass das Flachkabel als bandförmiger Kunststoffträger ausgebildet ist, der beidseitig mit Leiterbahnen belegt ist. Durch die beidseitige Belegung des Kabels mit Leiterbahnen wird eine Verringerung der Breite des Kabels und damit des erforderlichen Bauraums erreicht.

Ein Stecker mit in einer Ebene angeordneten Kontaktflächen zur Herstellung einer elektrischen Verbindung zu Leiterbahnen eines Flachkabels und einem Eingriffselement zur Zentrierung des Flachkabels in dem Stecker ist erfindungsgemäß dadurch gekennzeichnet, dass die Breite der Kontaktflächen und/oder der Abstand benachbarter Kontaktflächen unterschiedlich ist. Weitere vorteilhafte Ausgestaltungen sind in den Unteransprüchen angegeben.

Die Erfindung wird nachfolgend anhand eines Ausführungsbeispiels und der Zeichnung näher erläutert. Es zeigen:
- Fig. 1:: ein als flexible Folie ausgebildetes Flachkabel,
- Fig. 2:: einen erfindungsgemäßen Stecker .

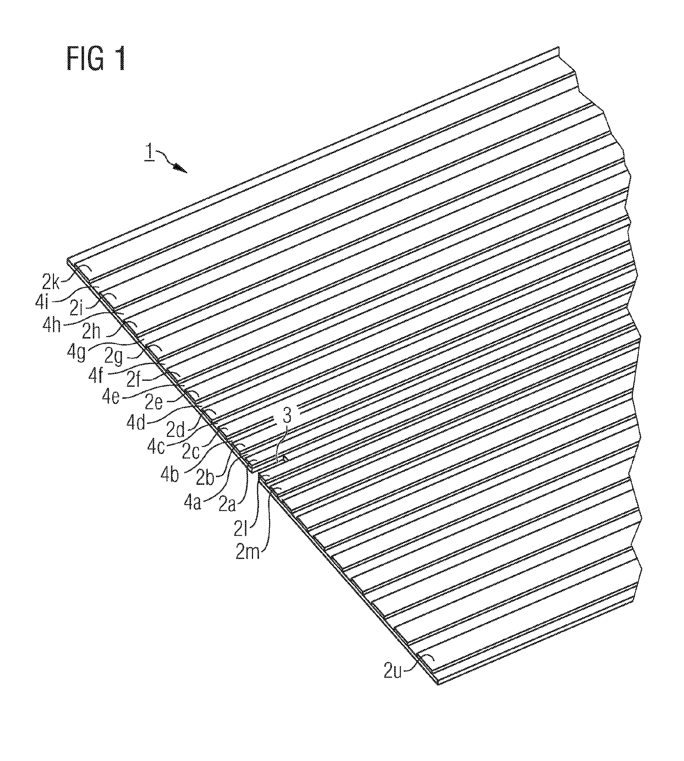

Fig. 1 zeigt ein Flachkabel 1 mit einer Vielzahl von Leiterbahnen 2. Das Flachkabel 1 ist als flexible Folie ausgebildet, auf die die Leiterbahnen 2 aufgebracht sind. Das Flachkabel 1 weist eine mittig zur Breitseite des Kabels angebrachte Aussparung 3 auf. Ausgehend von der Aussparung 3 nimmt die Breite der Leiterbahnen 2 zum Rand des Kabels hin kontinuierlich zu. So weist die Leiterbahn 2b eine größere Breite auf als die Leiterbahn 2a, die Leiterbahn 2c weist eine größere Breite auf als die Leiterbahn 2b, die Leiterbahn 2d weist eine größere Breite als die Leiterbahn 2c auf usw.. Auch die Abstände 4 zwischen den Leiterbahnen 2 wachsen mit zunehmendem Abstand von der Aussparung 3. So ist der Abstand 4b zwischen den Leiterbahnen 2b und 2c größer als der Abstand 4a zwischen den Leiterbahnen 2a und 2b. Der Abstand 4c zwischen den Leiterbahnen 2c und 2d ist wiederum größer als der Abstand 4b zwischen den Leiterbahnen 2b und 2c usw..

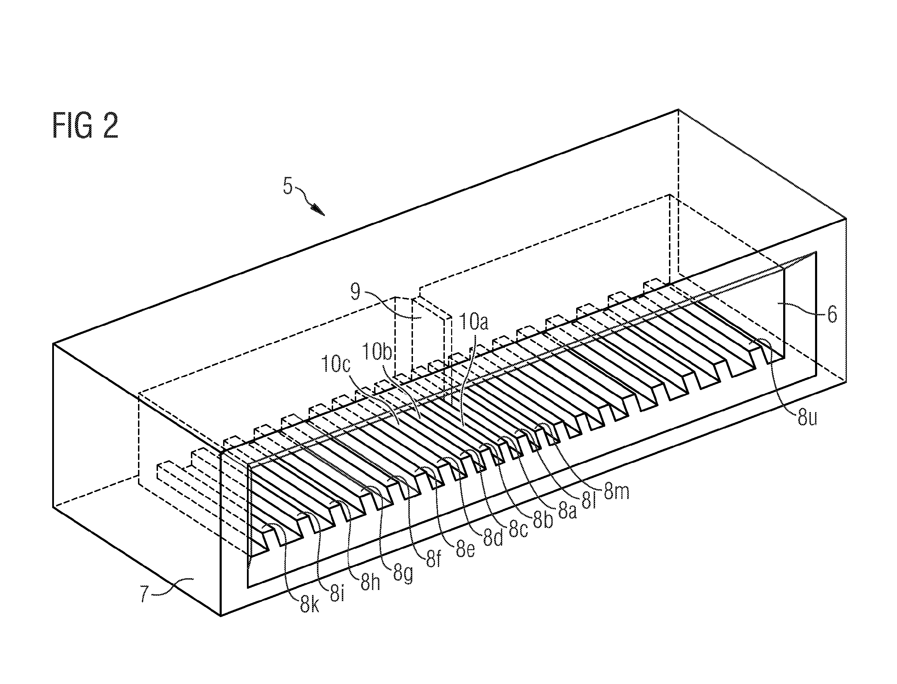

Fig. 2 zeigt einen Stecker 5, in dessen Öffnung 6 das Flachkabel 1 eingesteckt wird. Der Stecker 5 weist ein Steckergehäuse 7 auf, das in Fig. 2 durchsichtig gezeichnet ist. Im Inneren weist der Stecker 5 Kontaktflächen 8 auf, die bei eingestecktem Flachkabel mit den Leiterbahnen 4 in elektrisch leitfähigem Kontakt stehen. Die Kontaktflächen 8 sind in nicht dargestellter Weise am Stecker 5 nach außen geführt, um eine Verbindung mit einer Leiterplatte herzustellen. Der Stecker 5 weist weiterhin ein Eingriffselement 9 auf, das in die Ausnehmung 3 des Flachkabels 1 eingreift. Hierdurch wird eine Zentrierung des Flachkabels 1 in dem Stecker 5 erreicht. Der Abstand 10 zwischen den Kontaktflächen 8 ist an die Breite der Leiterbahnen 2 angepasst. Damit steigt der Abstand zwischen den Kontaktflächen mit zunehmender Entfernung der Kontaktflächen von dem Eingriffselement 9 an. Der Abstand 10b ist also größer als der Abstand 10a, der Abstand 10c ist größer als der Abstand 10b usw..

Aufgrund der Toleranzen des Flachkabels und des Steckers wächst üblicherweise die Positionierungsgenauigkeit zwischen Kabel 1 und Stecker 5 mit zunehmenden Abstand von dem Eingriffselement 9 bzw. der Ausnehmung 3 durch Addition der Einzeltoleranzen der Leiterbahnen 2, der Kontaktflächen 8 und der Abstände 4, 10. Durch die zunehmende Breite der Leiterbahnen 2 bzw. der Abstände 10 zwischen den Kontaktflächen 8 mit zunehmenden Abstand von der Aussparung 3 bzw. dem Eingriffselement 9 wird diesen zunehmenden Abweichungen Rechnung getragen und auch bei den weiter am Rand liegenden Leiterbahnen 2k, 2u und Kontaktflächen 8k, 8u noch eine sichere Überlappung erreicht.

## Patentansprüche

1. Mehrpoliges Verbindungskabel, das als flexibles Flachkabel (1) mit mehreren nebeneinander angeordneten Leiterbahnen (2) ausgebildet und an mindestens einem Kabelende mit einem Stecker (5) versehen ist, wobei die Leiterbahnen (2) am Kabelende elektrisch leitend mit Kontaktflächen (8) des Steckers (5) kontaktiert sind und das Flachkabel (2) und der Stecker (5) Mittel zum Zentrieren des Flachkabels in dem Stecker (5) aufweisen, **dadurch gekennzeichnet, dass** die Breite der Kontaktflächen (8) und/oder der Abstand (10) benachbarter Kontaktflächen (8) sowie daran angepasst die Breite der Leiterbahnen (2) und/oder der Abstand (4) benachbarter Leiterbahnen (2) unterschiedlich ist.

2. Verbindungskabel nach Anspruch 1, **dadurch gekennzeichnet, dass** die Mittel zum Zentrieren des Flachkabels (1) eine mittig in Querrichtung des Flachkabels (1) angeordnete Aussparung (3) umfassen, in die ein Eingriffselement (9) des Steckers (5) eingreift.

3. Verbindungskabel nach Anspruch 2, **dadurch gekennzeichnet, dass** die Aussparung (3) und das Eingriffselement (9) keilförmig ausgebildet sind.

4. Verbindungskabel nach einem der vorhergehenden Ansprüche, **dadurch gekennzeichnet, dass** der Abstand (4) zwischen benachbarten Leiterbahnen (2) von der mittig ausgelegten Aussparung (3) in beide Richtungen zum Kabelrand hin anwächst.

5. Verbindungskabel nach einem der vorhergehenden Ansprüche, **dadurch gekennzeichnet, dass** das Flachkabel (1) als bandförmiger Kunststoffträger ausgebildet ist, der beidseitig mit Leiterbahnen (2) belegt ist.

6. Verbindungskabel nach einem der vorhergehenden Ansprüche, **dadurch gekennzeichnet, dass** das Flachkabel (2) als flexible Folie ausgebildet ist.

7. Stecker mit in einer oder mehreren Ebenen angeordneten Kontaktflächen (8) zur Herstellung einer elektrischen Verbindung zu Leiterbahnen (2) eines Flachkabels (1) und einem Eingriffselement (9) zur Zentrierung des Flachkabels (1) in dem Stecker (5), **dadurch gekennzeichnet, dass** die Breite der Kontaktflächen (8) und/oder der Abstand (10) benachbarter Kontaktflächen (8) unterschiedlich ist.

8. Stecker nach Anspruch 7, **dadurch gekennzeichnet, dass** das Eingriffselement (9) mittig zur Kabelaufnahmeöffnung (6) des Steckers (5) angeordnet ist.

9. Stecker nach einem der vorhergehenden Ansprüche, **dadurch gekennzeichnet, dass** das Eingriffselement (9) keilförmig ausgebildet ist.

10. Stecker nach einem der vorhergehenden Ansprüche 8 oder 9, **dadurch gekennzeichnet, dass** der Abstand (10) zwischen benachbarten Kontaktflächen (8) von dem mittig angeordneten Eingriffselement (9) in beide Richtung hin anwächst.
